# EUROPEAN PATENT APPLICATION

(11) **EP 2 369 903 A1**
(43) Date of publication of application: **28.09.2011**
(21) Application number: 10015148.9
(22) Date of filing: 30.11.2010
(51) Int. Cl.: H05K 1/02, H01L 33/64

(54) **Substrate for light-emitting element and light-emitting device**

(30) Priority: 24.03.2010 JP 2010068812; 20.10.2010 JP 2010235799
(71) Applicant: ASAHI GLASS COMPANY, LIMITED, Chiyoda-ku, Tokyo 100-8405 (JP)
(72) Inventor: Nakayama, Katsuyoshi, Tokyo 100-8405 (JP)
(74) Representative: Müller-Boré & Partner Patentanwälte

(57) **Abstract**

To provide a substrate for light-emitting element, which is capable of sufficiently dissipating heat generation of a light-emitting element solely by a heat dissipation layer disposed in parallel with a light-emitting element-mounting surface of the substrate, which is economically advantageous as compared with thermal vias.

A substrate for light-emitting element, which comprises a substrate main body made of a sintered product of a first glass ceramics composition comprising a glass powder and a ceramics filler, wherein a surface on the side where a light-emitting element is to be mounted, is regarded as its main surface, and parts of wiring conductors for electrically connecting electrodes of the light-emitting element and an external circuit, are provided on the main surface; a heat dissipation layer formed on the substrate main body in such a shape to exclude said parts of wiring conductors and the vicinity around them and the periphery of the main surface, made of a metal material containing silver, having a thickness of from 8 to 50µm and having a flat surface; and an insulating protective layer formed to cover the entirety of the heat dissipation layer including its edge and having a flat surface.

## Description

The present invention relates to a substrate for light-emitting element and a light-emitting device employing it, particularly to a substrate for light-emitting element having thermal resistance reduced and a light-emitting device employing it.

In recent years, along with a tendency to high brightness and whitening of a light-emitting diode element, a light-emitting device employing a light-emitting diode element has been used for backlights of mobile phones or liquid crystal TVs, liquid crystal displays, etc. However, along with a tendency to high brightness of a light-emitting diode element, heat generation is also increasing, and the temperature increases excessively, whereby adequate emission brightness has not necessarily been obtainable. Therefore, as a substrate for light-emitting element capable of mounting a light-emitting element such as a light-emitting diode element, one capable of readily dissipating heat generated from the light-emitting element and capable of obtaining sufficient emission brightness, has been desired.

Heretofore, as a substrate for a light-emitting element, an alumina substrate has, for example, been used. However, the thermal conductivity of the alumina substrate is not necessarily high at a level of from about 15 to 20 W/m·K. Accordingly, it is also studied to employ an aluminum nitride substrate having a higher thermal conductivity.

However, the aluminum nitride substrate has drawbacks such that the cost of raw materials is high, and it is hardly sintered, whereby high temperature firing will be required, thus leading to an increase in the process cost. Further, the thermal expansion coefficient of the aluminum nitride substrate is as small as 4×10⁻⁶ to 5×10⁻⁶/°C, and when it is mounted on a printed substrate having a thermal expansion coefficient of at least 9×10⁻⁶/°C as a universal product, adequate connection reliability cannot necessarily be obtainable due to the difference in the thermal expansion.

In order to solve such problems, it has been studied to employ a low temperature co-fired ceramics substrate (hereinafter referred to as a LTCC substrate) as the substrate for light-emitting element. The LTCC substrate comprises, for example, glass and an alumina filler; the difference in their refractive indices is large; and their interfaces are many; and the thickness is larger than the wavelength to be used, whereby a high reflectance can be obtained. It is thereby possible to efficiently utilize light from the light-emitting element, and as a result, it is possible to reduce the quantity of heat generation. Further, it is composed of inorganic oxides which are less susceptible to deterioration by a light source, whereby a constant color can be maintained over a long period of time.

Such a LTCC substrate does not necessarily have a high thermal conductivity, and accordingly, it is known to reduce the thermal resistance, for example, by providing thermal vias made of a highly thermal conductive material such as a metal. As such thermal vias, it is known to provide, for example, a plurality of them each having a size smaller than the light-emitting element or to provide only one thermal via having a size substantially equal to the light-emitting element (e.g. Patent Document 1).

Further, Patent Document 2 discloses that in a light-emitting device having such a construction that a reflection layer of e.g. silver or a silver alloy is provided on a substrate, the reflection layer contributes to heat dissipation in the substrate planar direction, and it is preferred to provide heat dissipation vias in order to increase the heat dissipation in a direction perpendicular to the substrate in addition to the heat dissipation by the reflection layer.

On the other hand, apart from a LTCC substrate, in a flexible print circuit substrate in consideration of heat dissipation from a light-emitting diode element, a technique has been proposed to provide a heat dissipation layer made of a metal material such as a copper foil or an alumina foil on a surface on the side opposite to the insulating substrate surface having a circuit pattern formed thereon (e.g. Patent Document 3).

As a means to dissipate heat generated from a light-emitting element, a heat dissipation layer in parallel with the light-emitting element-mounting surface is economically superior to thermal vias, however, a LTCC substrate for light-emitting element having a sufficient heat dissipation property equal to thermal vias solely by a heat dissipation layer in parallel with the mounting surface, has not been obtained. Further, thermal vias are not only disadvantageous from the viewpoint of the costs but also problematic in that they tend to deteriorate planarity and adversely affect the adhesion between the light-emitting element and the substrate.
Patent Document 1: JP-A-2006-41230
Patent Document 2: JP-A-2010-34487
Patent Document 3: JP-A-2010-10298

The present invention has been made to solve the above-described problems, and it is an object of the present invention to provide a substrate for light-emitting element, which has a sufficient heat dissipation property solely by a heat dissipation layer in parallel with a light-emitting element-mounting surface of the substrate, which is economically advantageous as compared with thermal vias. Further, it is another object of the present invention to provide a light-emitting device employing such a substrate for light-emitting element.

The substrate for light-emitting element of the present invention comprises a substrate main body made of a sintered product of a first glass ceramics composition comprising a glass powder and a ceramics filler, wherein a surface on the side where a light-emitting element is to be mounted, is regarded as its main surface, and parts of wiring conductors for electrically connecting electrodes of the light-emitting element and an external circuit, are provided on the main surface; a heat dissipation layer formed on the substrate main body in such a shape to exclude said parts of wiring conductors and the vicinity around them and the periphery of the main surface, made of a metal material containing silver, having a thickness of from 8 to 50 µm and having a flat surface; and an insulating protective layer formed to cover the entirety of the heat dissipation layer including its edge and having a flat surface.

In the substrate for light-emitting element of the present invention, the above substrate main body preferably has no thermal via.

In the substrate for light-emitting element of the present invention, the heat dissipation layer preferably has a surface roughness Ra of at most 0.15 µm at least at a portion where the light-emitting element is to be mounted. Further, the insulating protective layer preferably has a surface roughness Ra of at most 0.03 µm at least at a portion where the light-emitting element is to be mounted. In the substrate for light-emitting element of the present invention, the insulating protective layer preferably has a thickness of from 5 to 150 µm.

In the substrate for light-emitting element of the present invention, the insulating protective layer is preferably made of a sintered product of a second glass ceramics composition comprising glass or a glass powder and a ceramics filler, and the ceramics filler contained in the second glass ceramics composition is preferably a mixture of an alumina powder and a zirconia powder.

In the substrate for light-emitting element of the present invention, the wiring conductors preferably have, as parts thereof, element connection terminals to be connected to the electrodes of the light-emitting element and external connection terminals to be connected to an external circuit, and an electroconductive protective layer is preferably formed on both terminals to cover their entirety including their edges. Further, the electroconductive protective layer is preferably a metal-plated layer having a gold-plated layer at least as the outermost layer.

The light-emitting device of the present invention comprises the above substrate for light-emitting element of the present invention and a light-emitting element mounted thereon.

By the substrate for light-emitting element of the present invention, it is possible to sufficiently dissipate heat generation of a light-emitting element solely by a heat dissipation layer in parallel with a light-emitting element-mounting surface of the substrate, which is economically advantageous as compared with thermal vias. Further, by using the substrate for light-emitting element of the present invention, it is possible to obtain a sufficient heat dissipation property without using thermal vias which deteriorate planarity of the substrate surface, whereby there is a merit in that adhesion between the light-emitting element and the substrate becomes easy. Further, according to the present invention, by mounting a light-emitting element on such a substrate for light-emitting element, it is possible to obtain a light-emitting device capable of obtaining a sufficient emission brightness.
Fig. 1 is a plan view and cross-sectional view illustrating an example of the first embodiment of the substrate for light-emitting element and the light-emitting device of the present invention.
Fig. 2 is a view schematically illustrating a part (step (A)) of steps for producing the substrate for light-emitting element shown in Fig. 1.
Fig. 3 is a view schematically illustrating parts (steps (B) to (D)) of the steps for producing the substrate for light-emitting element shown in Fig. 1.
Fig. 4 is a plan view and cross-sectional view illustrating an example of the second embodiment of the substrate for light-emitting element and the light-emitting device of the present invention.
Fig. 5 is a view schematically illustrating a part (step (A)') of steps for producing the substrate for light-emitting element shown in Fig. 4.
Fig. 6 is a view schematically illustrating parts (steps (B)' and (C)') of the steps for producing the substrate for light-emitting element shown in Fig. 4.

Now, the embodiments of the present invention will be described with reference to the drawings. However, it should be understood that the present invention is by no means restricted by the following description.

The substrate for light-emitting element of the present invention comprises a substrate main body made of a sintered product of a first glass ceramics composition comprising a glass powder and a ceramics filler, wherein a surface on the side where a light-emitting element is to be mounted, is regarded as its main surface, and parts of wiring conductors for electrically connecting electrodes of the light-emitting element and an external circuit, are provided on the main surface; a heat dissipation layer formed on the substrate main body in such a shape to exclude said parts of wiring conductors and the vicinity around them and the periphery of the main surface, made of a metal material containing silver, having a thickness of from 8 to 50 µm and having a flat surface; and an insulating protective layer formed to cover the entirety of the heat dissipation layer including its edge and having a flat surface.

Here, in this specification, the above "wiring conductors" which the substrate for light-emitting element has, is one used as a term which generally refers to all conductors relating to electrical wiring provided to electrically connect electrodes of a mounted light-emitting element to an external circuit, such as element connection terminals connected to the electrodes of the light-emitting element, inner layer wirings provided in the substrate (including via conductors passing through the substrate), external connection terminals connected to an external circuit, etc.

According to the present invention, on the main surface of a LTCC substrate on the side where a light-emitting element is to be mounted, a metal layer having a flat surface containing silver is formed in a thickness of from 8 to 50 µm in such a shape to exclude the above-mentioned parts of the wiring conductors and the vicinity around them and the periphery of the main surface, and the insulating protective layer to cover such a metal layer is also made to have a surface planarity, whereby it has been made possible to sufficiently dissipate heat generated from the light-emitting element without providing thermal vias which require an increase of the production steps or require a large amount of silver, etc. to be filled. Further, according to the present invention, by suitably selecting the thickness or material of the insulating protective layer to insulate and protect such a heat dissipation layer, the above heat dissipation layer has been made possible to function as a reflection layer to reflect light emitted from the light-emitted element to the light-extraction side. It is thereby made possible to obtain a sufficient emission brightness when a light-emitting element is mounted on this substrate for light-emitting element to form a light-emitting device.

Now, the first embodiment of the present invention wherein a glass layer is employed as the insulating protective layer, and the second embodiment of the present invention wherein a layer of a sintered product of the second glass ceramics composition comprising a glass powder and a ceramics filler, is employed as the insulating protective layer, will be described.

### <First Embodiment>

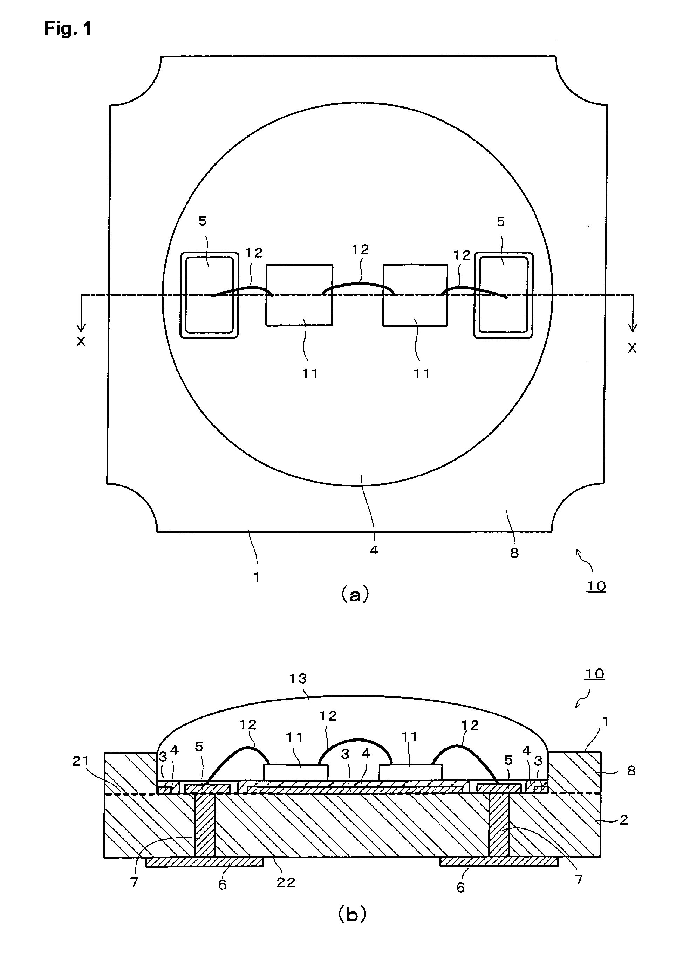

Fig. 1 is a plan view (a) illustrating an example of the substrate 1 for light-emitting element according to the first embodiment of the present invention and the light-emitting device 10 employing it, and a cross-sectional view (b) along its X-X line.

On the substrate 1 for light-emitting element of the present invention, for example, as shown in Fig. 1, two light-emitting elements 11 are mounted so that they are electrically connected in series. This substrate 1 for light-emitting element is used for a light-emitting device 10 wherein light-emitting elements 11 are electrically connected in series by bonding wires 12, and a sealing layer 13 is provided to cover these light-emitting elements 11 and the bonding wires 12. That is, in the light-emitting device 10 shown in Fig. 1, the portion excluding the light-emitting elements 11, the bonding wires 12 and the sealing layer 13, is the substrate 1 for light-emitting element of the present invention.

Here, the first embodiment of the present invention will be described with reference to a light-emitting device and a substrate for the light-emitting device wherein two light-emitting elements 11 are mounted so that they are electrically connected in series. However, the number of light-emitting elements to be mounted, the electrical connection method such as in series or in parallel in the case of mounting a plurality of light-emitting elements, etc. are not particularly limited. The constructions of individual components which will be described hereinafter, may suitably be adjusted depending upon the design of the light-emitting device to be used, within the range of the present invention.

The substrate 1 for light-emitting element has a substantially flat plate-form substrate main body 2 which mainly constitutes the substrate. This substrate main body 2 is made of a sintered product of a first glass ceramics composition comprising a glass powder and a ceramics filler. The substrate main body 2 has, as its main surface 21, a surface on the side where a light-emitting element is to be mounted when used as a substrate for light-emitting element, and in this embodiment, a surface on the opposite side is regarded as a rear surface 22. The substrate 1 for light-emitting element has a frame member 8 along the periphery of the main surface 21 of the substrate main body to form a cavity having a bottom surface (hereinafter referred to as "cavity bottom surface") constituted by a center circular portion of the main surface 21 of the substrate main body 2. The material to constitute the frame member 8 is not particularly limited, but it is preferred to use the same one as the material constituting the substrate main body 2.

The substrate main body 2 preferably has a flexural strength of e.g. at least 250 MPa with a view to preventing damages, etc. during the mounting of light-emitting elements or during the use thereafter. The shapes, thicknesses, sizes, etc. of the substrate main body 2 and the frame member 8 are not particularly limited and may be the same as ones to be commonly used for a substrate for light-emitting element. Further, the raw material composition, firing conditions, etc. for the sintered product of the first glass ceramic composition comprising a glass powder and a ceramics filler to constitute the substrate main body 2, will be described in the process for producing a substrate for light-emitting element given hereinafter.

In a case where a light-emitting device 10 is to be prepared by using the substrate 1 for light-emitting element, on the main surface 21 side of the substrate main body 2, the above-mentioned two light-emitting elements 11 are mounted as shown in Fig. 1 substantially at the center portion of the bottom surface of the cavity so that the centers of these two light-emitting elements 11 are disposed on a straight line passing through the center of the bottom surface of the cavity.

In the substrate 1 for light-emitting element, on the main surface 21 of the substrate main body 2, element connection terminals 5 each electrically connected to one of the pair of electrodes of the two light-emitting elements 11, are provided in a pair of substantially rectangular shapes at a peripheral portion outside the two light-emitting elements 11, specifically on both sides to face them, respectively.

In the light-emitting device 10, such two light-emitting elements 11 are electrically connected in series. Specifically, one of the pair of electrodes of each of the two light-emitting element 11, which is located outside, is electrically connected via a bonding wire 12 to an element connection terminal 5 located outside each light-emitting element 11. Further, one of the pair of electrodes of each of the two light-emitting elements 11, which is located inside, is electrically connected to each other via a bonding wire 12.

On the rear surface 22 of the substrate main body 2, a pair of external connection terminals 6 are provided which are electrically connected to an external circuit, and inside the substrate main body 2, a pair of via conductors 7 are provided which electrically connect the above element connection terminals 5 and the external connection terminals 6. With respect to the element connection terminals 5, the external connection terminals 6 and the via conductors 7, so long as they are electrically connected in the order of the light-emitting elements, the element connection terminals 5, the via conductors 7, the external connection terminals 6 and the external circuit, their positions or shapes are not limited to those shown in Fig. 1 and may be optionally adjusted.

The material to constitute such element connection terminals 5, external connection terminals 6 and via conductors 7, i.e. wiring conductors, is not particularly limited so long as it is the same constituting material as wiring conductors to be commonly used for a substrate for light-emitting element. The material to constitute such wiring conductors may specifically be a metal material composed mainly of copper, silver, gold or the like. Among such metal materials, a metal material made of silver, silver and platinum, or silver and palladium is preferably employed.

Further, the element connection terminals 5 or the external connection terminals 6 preferably have such a construction that on a metal conductor layer made of such a metal material and preferably having a thickness of from 5 to 15 µm, an electroconductive protective layer (not shown) to protect the metal conductor layer from oxidation or sulfurization and having an electrical conductivity, is formed to cover the entirety of the metal conductor layer including its edge. The electroconductive protective layer is not particularly limited so long as it is made of an electroconductive material having a function to protect the above metal conductor layer. Specifically, an electroconductive protective layer formed by nickel plating, chromium plating, silver plating, nickel/silver plating, gold plating or nickel/gold plating may be mentioned.

In the present invention, among them, as an electroconductive protective layer to cover and protect the above element connection terminals 5 and the external connection terminals 6, it is preferred to employ a metal-plated layer having a gold-plated layer at least as the outermost layer, for example, from such a viewpoint that good bonding is obtainable with bonding wires to be used for connection with electrodes of after-mentioned light-emitting elements or with other connection materials. The electroconductive protective layer may be formed solely from a gold-plated layer, but more preferably formed as a nickel/gold-plated layer having a gold plating applied on nickel plating. In such a case, with respect to the thickness of the electroconductive protective layer, it is preferred that the nickel-plated layer is from 2 to 20 µm, and the gold-plated layer is from 0.1 to 1.0 µm.

On the main surface 21 of the substrate main body of the substrate 1 for light-emitting element, a heat dissipation layer made of a metal material containing silver, having a thickness of from 8 to 50 µm and having a flat surface, is formed in such a shape to exclude a portion on the main surface 21 of the substrate main body on which the frame member 8 is formed i.e. the periphery of the main surface 21, and portions where the above-mentioned pair of element connection terminals 5 are provided and the vicinity around them.

The metal material containing silver to constitute the heat dissipation layer may specifically be a metal material composed of silver, silver and platinum, or silver and palladium. The metal material composed of silver and platinum or palladium may specifically be a metal material wherein the proportion of platinum or palladium to the entire amount of the metal material is at most 5 mass%. Among them, a heat dissipation layer composed solely of silver is preferred from such a viewpoint that a high reflectance can be obtained in the present invention.

Further, the thickness of the heat dissipation layer 3 is from 8 to 50 µm, preferably from 10 to 20 µm, more preferably from 13 to 16 µm. If the thickness of the heat dissipation layer 3 is less than 8 µm, no adequate heat dissipation property can be obtained. On the other hand, if it exceeds 50 µm, such is economically disadvantageous, and a deformation due to a difference in thermal expansion from the substrate main body in the production process is likely to occur.

The heat dissipation layer 3 has a flat surface, and as such a surface planarization, specifically, the surface roughness Ra is preferably at most 0.15 µm, more preferably at most 0.1 µm, at least at a portion where a light-emitting element 11 is mounted, from the viewpoint of production efficiency while securing a sufficient heat dissipation property. Here, the surface roughness Ra is meant for an arithmetic mean roughness Ra, and the value of the arithmetic mean roughness Ra is one represented by JIS B0601 (1994), 3 "Definition and Representation of Defined Arithmetic Mean Roughness".

In the example shown in Fig. 1, a heat dissipation layer 3 is not provided between the substrate main body 2 and the frame member 8, but, as the case requires, a heat dissipation layer 3 may be provided between the two continuously from the end of the cavity bottom surface within a range not to reach the edge of the main surface 21 of the substrate main body, in consideration of the adhesion between the substrate main body 2 and the frame member 8.

Further, in the present invention, a metal having thermal conductivity and not containing silver, e.g. a metal layer made of copper, may be provided between the heat dissipation layer 3 and the substrate main body 2, as the case requires, for the purpose of e.g. further improving the heat dissipation property, within a range not to impair the surface planarity of the heat dissipation layer 3.

On the main surface 21 of the substrate main body of the substrate 1 for light-emitting element, an overcoat glass layer 4 is further formed as an insulating protective layer having a flat surface to cover the entirety of the heat dissipation layer 3 including its edge. Here, the edge of the overcoat glass layer 4 may be in contact with the element connection terminals 5 so long as the insulation between the heat dissipation layer 3 and the element connection terminals 5 provided on the main surface 21 of the substrate main body is secured, but in consideration of a possible trouble in the production, the distance between them is preferably at least 75 µm, more preferably at least 100 µm.

Further, the distance between the edge of the heat dissipation layer 3 and the edge of the overcoat glass layer 4 covering it is preferably as short as possible within a range where the heat dissipation layer 3 is sufficiently protected from any external deterioration factor. Specifically, it is preferably from 10 to 50 µm, more preferably from 20 to 30 µm. If this distance is less than 10 µm, by exposure of the dissipation layer 3, it is likely that oxidation or sulfurization of the metal material containing silver constituting the heat dissipation layer 3 occurs to deteriorate the thermal conductivity or heat dissipation property, and if it exceeds 50 µm, the area of the region where the heat dissipation layer 3 is provided, consequently decreases to deteriorate the thermal conductivity or heat dissipation property.

With respect to the insulating protective layer in the present invention, its thickness is preferably from 5 to 150 µm in consideration of the economical efficiency, a deformation due to a difference in thermal expansion from the substrate main body, etc. while securing an adequate insulation and protection function, although it may also depends on the design of the light-emitting device. However, with respect to the thickness in a case where as in this example, the insulating protective layer is an overcoat glass layer 4, the upper limit is preferably at a level of 50 µm when a deformation due to a difference in thermal expansion from the substrate main body, etc. are taken into consideration.

The overcoat glass layer 4 as an insulating protective layer has a flat surface, and as its surface planarization, specifically, the surface roughness Ra is preferably at most 0.03 µm, more preferably at most 0.01 µm, at least at a portion where a light-emitting element 11 is mounted, from the viewpoint of the production efficiency while securing an adequate heat dissipation property. Further, the raw material composition relating to the overcoat glass layer will be described in the production process given hereinafter.

Here, in a substrate for light-emitting element, it is common to provide a thermal via immediately under the mounting portion for a light-emitting element in order to obtain a sufficient heat dissipation property. In such a case, a special method is employed in order to suppress surface irregularities at the mounting portion which are likely to result by forming the thermal via, but even by using such a method, the difference in height between the highest portion and the lowest portion of the surface irregularities can be suppressed merely at a level of at most 1 µm.

In the present invention, by the above construction, a sufficient heat dissipation property can be secured without providing a thermal via which is likely to cause the surface roughness at the light-emitting element-mounting portion, and therefore, the difference in height between the highest portion and the lowest portion of the surface irregularities at the light-emitting element-mounting portion is equal to the surface other than the mounting portion i.e. the surface of the insulating protective layer in the present invention and is usually at most 0.5 µm. That is, as compared with a case where the above thermal via is provided, by the construction of the present invention, while the heat dissipation property is equal, with respect to the planarity of the mounting portion, a high planarity can be obtained more easily than providing a thermal via.

In the foregoing, the substrate 1 for light-emitting element according to the first embodiment of the present invention has been described. The light-emitting device 10 according to the first embodiment of the present invention is constructed in such a manner that on the mounting portion of such a substrate 1 for light-emitting element, light-emitting elements 11 such as light-emitting diode elements are mounted by a die bond agent such as silicon die bond agent, their electrodes not shown are connected to element connection terminals 5 by bonding wires 12, and a sealing layer 13 is provided to cover the light-emitting elements 11 and the bonding wires 12 and to fill the cavity.

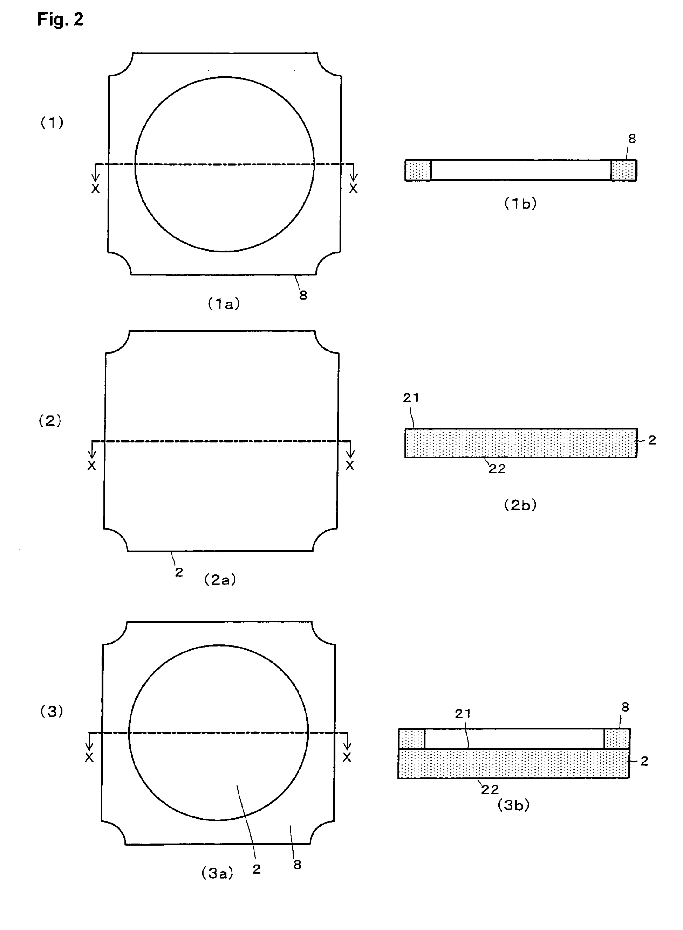

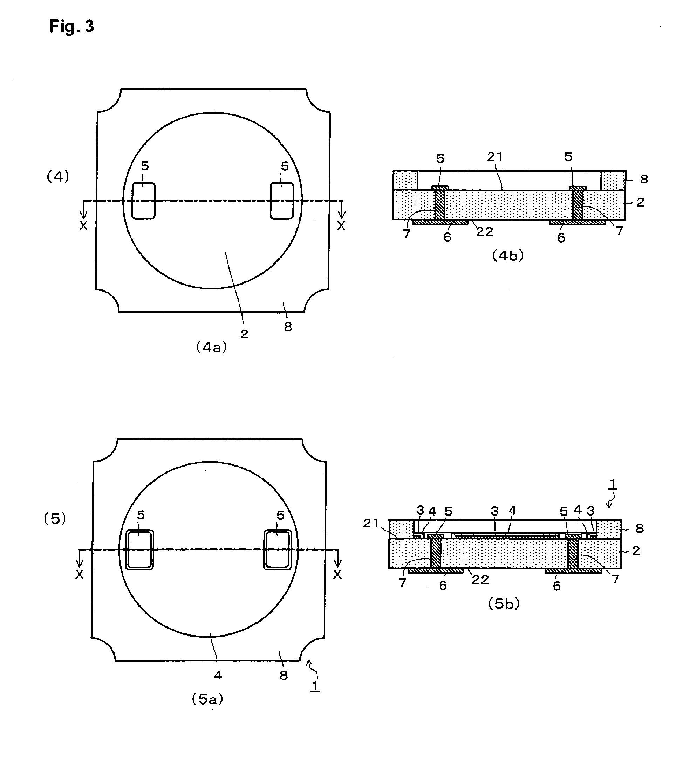

The substrate for light-emitting element according to the first embodiment of the present invention may, for example, be prepared by a process comprising the following steps (A) to (E). Now, taking the substrate 1 for light-emitting element of the light-emitting device 10 shown in Fig. 1 as an example, the process will be described with reference to Figs. 2 and 3, and the components to be used for the preparation will be described by attaching the same symbols as for the components in a completed product.
(A) A step of preparing a substantially flat plate-form green sheet 2 for main body having, as the main surface 21, a surface on the side where light-emitting elements are to be mounted, to constitute a substrate main body 2 of the substrate for light-emitting element, and a green sheet 8 for frame member to constitute the frame member 8, by using a first glass ceramics composition comprising a glass powder and a ceramics filler, and laminating the green sheet 8 for frame member on the main surface of the green sheet 2 for the main body (hereinafter referred to as "green sheet lamination step"),
(B) a step of forming paste layers 5 for element connection terminals at two locations on the main surface 21 of the green sheet for the main body of the above green sheet laminate, paste layers 7 for via conductors to electrically connect the paste layers 5 for element connection terminals to paste layers 6 for external connection terminals to be formed on the rear surface 22, and paste layers 6 for external connection terminals on the rear surface 22, to electrically connect the paste layers 5 for element connection terminals to an external circuit via the paste layers for via conductors and themselves (hereinafter referred to as "wiring conductor paste layer-forming step"),
(C) a step for forming a metal paste layer 3 for heat dissipation layer by screen printing on the main surface 21 of the green sheet 2 for main body in a region excluding the frame member 8-lamination portion, and the paste layers 5 for element connection terminals and the vicinity around them (hereinafter referred to as "metal paste layer-forming step for heat dissipation layer"),
(D) a step for forming an overcoat glass paste layer 4 on the main surface 21 of the green sheet for main body to cover the entirety of the above metal paste layer 3 for heat dissipation layer including its edge, excluding the frame member 8 lamination portion, and the paste layers 5 for element connection terminals and the vicinity around them, on the main surface 21 of the green sheet 2 for main body, thereby to obtain a non-sintered substrate for light-emitting element (hereinafter referred to as "overcoat glass paste layer-forming step"),
(E) a step for firing the above non-sintered substrate for light-emitting element at a temperature of from 800 to 880°C (hereinafter referred to as "firing step").

### (A) GREEN SHEET LAMINATION STEP

Fig. 2 is a view schematically illustrating the green sheet lamination step. The green sheet 8 for frame member as shown in Fig. 2(1) i.e. a plan view (1a) and a cross-sectional view (1b) along its X-X line, and the green sheet 2 for main body as shown in Fig. 2(2) i.e. a plan view (2a) and a cross-sectional view (2b) along its X-X line, may be produced by preparing a slurry by adding a binder and, as the case requires, a plasticizer, a dispersing agent, a solvent, etc. to the first glass ceramics composition comprising a glass powder and a ceramics filler, forming the slurry into a sheet having a prescribed shape by e.g. a doctor blade method, followed by drying.

The glass powder for the substrate main body and the frame member (hereinafter referred to as "glass powder for substrate main body") is not necessarily limited, but one having a glass transition point (Tg) of at least 550°C and at most 700°C is preferred. If the glass transition point (Tg) is lower than 550°C, binder burn out tends to be difficult, and if it exceeds 700°C, the shrinkage start temperature tends to be high, whereby the dimensional precision is likely to deteriorate.

Further, it is preferred that when it is fired at a temperature of from 800°C to 880°C, crystals will precipitate. In the case of one where no crystal will precipitate, it is likely that no adequate mechanical strength can be obtained. Further, preferred is one having a crystallization peak temperature (Tc) of at most 880°C as measured by DTA (differential thermal analysis). If the crystallization peak temperature (Tc) exceeds 880°C, the dimensional precision is likely to deteriorate.

Such a glass powder for substrate main body is, for example, preferably one comprising from 57 mol% to 65 mol% of SiO₂, from 13 mol% to 18 mol% of B₂O₃, from 9 mol% to 23 mol% of CaO, from 3 mol% to 8 mol% of Al₂O₃ and from 0.5 mol% to 6 mol% in total of at least one selected from K₂O and Na₂O. By using such a glass powder, it becomes easy to improve the planarity of the surface of the substrate main body.

Here, SiO₂ will be a network former of glass. If the content of SiO₂ is less than 57 mol%, it tends to be difficult to obtain stabilized glass, and the chemical durability is likely to deteriorate. On the other hand, if the content of SiO₂ exceeds 65 mol%, the glass melting temperature or the glass transition point (Tg) tends to be too high. The content of SiO₂ is preferably at least 58 mol%, more preferably at least 59 mol%, particularly preferably at least 60 mol%. Further, the content of SiO₂ is preferably at most 64 mol%, more preferably at most 63 mol%.

B₂O₃ will be a network former of glass. If the content of B₂O₃ is less than 13 mol%, the glass melting point or the glass transition point (Tg) is likely to be too high. On the other hand, if the content of B₂O₃ exceeds 18 mol%, it tends to be difficult to obtain stable glass, and the chemical durability is also likely to deteriorate. The content of B₂O₃ is preferably at least 14 mol%, more preferably at least 15 mol%. Further, the content of B₂O₃ is preferably at most 17 mol%, more preferably at most 16 mol%.

Al₂O₃ is added in order to increase the stability, chemical durability and strength of glass. If the content of Al₂O₃ is less than 3 mol%, the glass is likely to be unstable. On the other hand, if the content of Al₂O₃ exceeds 8 mol%, the glass melting point or the glass transition point (Tg) is likely to be too high. The content of Al₂O₃ is preferably at least 4 mol%, more preferably at least 5 mol%. Further, the content of Al₂O₃ is preferably at most 7 mol%, more preferably at most 6 mol%.

CaO is added in order to increase the stability of glass or the precipitation property of crystals and to lower the glass melting temperature or the glass transition point (Tg). If the content of CaO is less than 9 mol%, the glass melting point is likely to be too high. On the other hand, if the content of CaO exceeds 23 mol%, the glass is likely to be unstable. The content of CaO is preferably at least 12 mol%, more preferably at least 13 mol%, particularly preferably at least 14 mol%. Further, the content of CaO is preferably at most 22 mol%, more preferably at most 21 mol%, particularly preferably at most 20 mol%.

K₂Oor Na₂O is added in order to lower the glass transition point (Tg). If the total content of K₂O and Na₂Ois less than 0.5 mol%, the glass melting point or the glass transition point (Tg) is likely to be too high. On the other hand, if the total content of K₂O and Na₂O exceeds 6 mol%, the chemical durability, particularly the acid resistance, is likely to deteriorate, and the electrical insulation property is also likely to deteriorate. The total content of K₂O and Na₂O is preferably from 0.8 mol% to 5 mol%.

The glass powder for substrate base body is not necessarily limited to one comprising only the above-described components and may contain other components within a range to satisfy various properties such as the glass transition point (Tg). When it contains such other components, their total content is preferably at most 10 mol%.

The glass powder for substrate base body can be obtained by producing a glass having the above-described glass composition by a melting method and grinding it by a dry grinding method or a wet grinding method. In the case of a wet grinding method, it is preferred to employ water as a solvent. The grinding can be carried out by using a grinding machine such as a roll mill, a ball mill or a jet mill.

The 50% particle size (D₅₀) of the glass powder for substrate base body is preferably from 0.5 µm to 2 µm. If the 50% particle size of the glass powder for substrate base body is less than 0.5 µm, the glass powder is likely to cohere, whereby the handling tends to be difficult, and it tends to be difficult to uniformly disperse it. On the other hand, if the 50% particle size of the glass powder for substrate base body exceeds 2 µm, the glass softening temperature is likely to rise, or the sintering is likely to be inadequate. The particle size can be adjusted, for example, by classification which is carried out after the grinding, as the case requires. In this specification, the particle size is a value obtained by a particle size analyzer of a laser diffraction scattering method. As the particle size analyzer of a laser diffraction scattering method, a laser diffraction particle size analyzer (tradename: SALD2100 manufactured by Shimadzu Corporation) was used.

On the other hand, as the ceramics filler, one which has been commonly used for the production of a LTCC substrate may be used without any particular restriction, and for example, an alumina powder, a zirconia powder, or a mixture of an alumina powder and a zirconia powder, may preferably be used. Further, the 50% particle size (D₅₀) of the ceramics filler is preferably e.g. from 0.5 µm to 4 µm.

The above glass powder and the ceramics filler are blended and mixed, for example, so that the glass powder would be from 30 mass% to 50 mass% and the ceramics filler would be from 50 mass% to 70 mass% to obtain a glass ceramics composition. To this glass ceramics composition, a binder, and, as the case requires, a plasticizer, a dispersing agent, a solvent, etc. are added to obtain a slurry.

As the binder, for example, a polyvinyl butyral or an acrylic resin may be suitably used. As the plasticizer, for example, dibutyl phthalate, dioctyl phthalate or butylbenzyl phthalate may be employed. Further, as the solvent, an organic solvent such as toluene, xylene, 2-propanol or 2-butanol may suitably be employed.

The slurry thus obtained is formed into a sheet having a prescribed shape by e.g. a doctor blade method, followed by drying to produce a green sheet 2 for main body and a green sheet 8 for frame member.

On the main surface of the green sheet 2 for main body produced as described above, the green sheet 8 for frame member is laminated to obtain a green sheet laminate of such a shape that as shown in Fig. 2(3), the substrate main body 2 finally has a cavity on its main surface, and its bottom surface forms a region where light-emitting elements are to be mounted.

### (B) WIRING CONDUCTOR PASTE LAYER-FORMING STEP

Then, at two locations on the main surface 21 of the green sheet for main body of the green sheet laminate thus obtained, paste layers 5 for element connection terminals, via conductor paste layers 7 to electrically connect the paste layers 5 for element connection terminals and paste layers 6 for external connection terminals to be formed on the rear surface 22 of the green sheet 2 for main body, and paste layers 6 for external connection terminals on the rear surface 22 to electrically connect the paste layers 5 for element connection terminals to an external circuit via the via conductor paste layers 7 and themselves, are formed in the prescribed sizes and shapes. Hereinafter, the green sheet laminate having such various wiring conductor paste layers formed will be referred to as the green sheet laminate provided with conductor paste layers. Fig. 3(4) shows a plan view (4a) of the green sheet laminate provided with conductive paste layers and a cross-sectional view (4b) along its X-X line.

The method for forming the paste layers 5 for element connection terminals, the paste layers 6 for external connection terminals and the paste layers 7 for via conductors may, for example, be a method of applying and filling a conductor paste by a screen printing method. The thicknesses of the paste layers 5 for element connection terminals and the paste layers 6 for external connection terminals to be formed, are adjusted so that the thicknesses of the finally obtainable element connection terminals and external connection terminals will be the prescribed thicknesses.

As the conductor paste, it is possible to use one formed into a paste by adding a vehicle such as ethyl cellulose and, as the case requires, a solvent, etc. to a metal powder containing e.g. copper, silver, gold or the like as the main component. Further, as the metal powder, a metal powder composed of silver, or a metal powder composed of silver and platinum or palladium, is preferably employed.

### (C) METAL PASTE LAYER-FORMING STEP FOR HEAT DISSIPATION LAYER

In (C) metal paste layer-forming step for heat dissipation layer, a metal paste layer 3 for heat dissipation layer containing a metal material containing silver is formed by screen printing on the main surface 21 of the green sheet 2 for main body of the green sheet laminate provided with conductor paste layers, obtained as described above, in a region excluding the frame member 8 lamination portion, and the paste layers 5 for element connection terminals and the vicinity around them. Here, (C) metal paste layer-forming step for heat dissipation layer may be carried out at the same time as the formation of the paste layers 5 for element connection terminals in the above step (B), for example, in a case where the above conductor paste and the metal paste for dissipation layer are made of the same paste material.

The metal paste for heat dissipation layer to be used for the above screen printing is a paste containing a metal material containing silver to constitute a heat dissipation layer 3. As such a material, silver, a mixture of silver and palladium, or a mixture of silver and platinum may, for example, be mentioned, as described above. However, for the above-mentioned reason, silver is preferably employed. The metal paste for heat dissipation layer may be one formed into a paste by adding a vehicle such as ethyl cellulose and, as the case requires, a solvent, etc. to a metal powder containing such a material as the main component. The thickness of the metal paste layer 3 for heat dissipation layer to be formed, is adjusted so that the thickness of the finally obtainable heat dissipation layer 3 will be the above-described desired thickness.

Further, in order to bring the surface roughness Ra of the finally obtainable heat dissipation layer 3 to the above-mentioned preferred range, it is preferred to use a powder having a small particle size distribution as the metal powder to be contained in the metal paste.

### (D) OVERCOAT GLASS PASTE LAYER-FORMING STEP

In (D) overcoat glass paste layer-forming step, an overcoat glass paste layer 4 is formed by screen printing on the main surface 21 of the green sheet for main body to cover the entirety of the metal paste layer 3 for heat dissipation layer formed in the above step (C), excluding the frame member 8 lamination portion, and the paste layers 5 for element connection terminals formed in the above step (B) and the vicinity around them. It is thereby possible to obtain a non-sintered substrate 1 for light-emitting element. Fig. 3(5) shows a plan view (5a) of the non-sintered substrate 1 for light-emitting element thus obtained and a cross-sectional view (5b) along its X-X line.

As such an overcoat glass paste, it is possible to employ one formed into a paste by adding a vehicle such as ethyl cellulose and, as the case requires, a solvent, etc. to a glass powder for overcoat glass layer (hereinafter referred to as "glass powder for glass layer"). The thickness of the overcoat glass paste layer 4 to be formed, is adjusted so that the thickness of the finally obtainable overcoat glass layer 4 will be the above-mentioned desired thickness.

The glass powder for glass layer may be one whereby a film-form glass is obtainable by firing in (E) firing step which is carried out subsequent to the step (D), and its 50% particle size (D₅₀) is preferably from 0.5 µm to 2 µm. Further, the surface roughness Ra of the overcoat glass layer 4 may be adjusted, for example, by the particle size of this glass powder for glass layer. That is, it is possible to adjust the surface roughness Ra to be within the above preferred range by using, as the glass powder for glass layer, one having a 50% particle diameter (D₅₀) within the above range which can be sufficiently melted during the firing and is excellent in fluidity.

### (E) FIRING STEP

After the above step (D), the obtained non-sintered substrate 1 for light-emitting element is subjected to binder burn out to remove the binder, etc. as the case requires, and then firing is carried out to sinter the glass ceramics composition, etc.

The binder burn out can be carried out by holding the substrate, for example, at a temperature of from 500°C to 600°C for from 1 hour to 10 hours. If the binder burn out temperature is lower than 500°C or the binder burn out time is less than 1 hour, the binder, etc. may not sufficiently be removed. On the other hand, when the binder burn out temperature is about 600°C, and the binder burn out time is about 10 hours, the binder, etc. can be sufficiently removed, and if the binder burn out temperature or time exceeding such a level, the productivity, etc. may deteriorate.

Further, the firing can be carried out by suitably adjusting the time within a temperature range of from 800°C to 930°C in consideration of only the productivity and securing dense structures of the substrate main body 2 and the frame member 8. However, in the present invention, a metal paste containing a metal powder containing silver is used as the metal paste for heat dissipation layer, whereby if the firing temperature exceeds 880°C, firing shrinkage tends to be excessive, and a prescribed shape may not be maintained. Accordingly, it is preferred to suitably adjust the time within a temperature range of from 800°C to 880°C.

Specifically, it is preferred to maintain a temperature of from 850°C to 880°C for from 20 minutes to 60 minutes, and it is particularly preferred to carry out the firing at a temperature of from 860°C to 880°C. If the firing temperature is lower than 800°C, the substrate main body 2 and the frame member 8 may not be obtained as ones having dense structures.

In such a manner, the non-sintered substrate 1 for light-emitting element is fired to obtain a substrate 1 for light-emitting element, and after the firing, as the case requires, it is possible to provide an electroconductive protective layer to be commonly used for conductor protection in a substrate for light-emitting element, made of the above-described nickel plating, chromium plating, silver plating, nickel/silver plating, gold plating or nickel/gold plating, to cover the entirety of the element connection terminals 5 and external connection terminals 6, as the case requires. Among them, nickel/gold plating is preferably employed, and for example, a nickel-plated layer may be formed by electrolytic plating by using e.g. nickel sulfamate bath, or a gold-plated layer may be formed by electrolytic plating by using gold potassium cyanide bath.

In the foregoing, the process for producing the substrate for light-emitting element according to the first embodiment of the present invention has been described, but the green sheet 2 for main body and the green sheet 8 for frame member may not necessarily be composed of a single green sheet and may be one wherein a plurality of green sheets are laminated. Further, the order to form the respective components, etc. may also be suitably changed within a range where the production of the substrate for light-emitting element is possible.

Further, in the above example of the substrate for light-emitting element, the substrate main body 2 and the frame member 8 are made of a sintered product of a glass ceramics composition comprising a glass powder and a ceramics filler, but they may be made of a ceramics such as alumina. In a case where the substrate main body 2 is to be made of a ceramics such as alumina, after sintering the substrate main body 2 by a firing step, the above steps (B), (C) and (D) are carried out, and then a second firing step is carried out.

### <Second Embodiment>

Now, a second embodiment of the present invention will be described wherein as an insulating protective layer, a layer of a sintered product of a second glass ceramics composition comprising a glass powder and a ceramics filler is used.

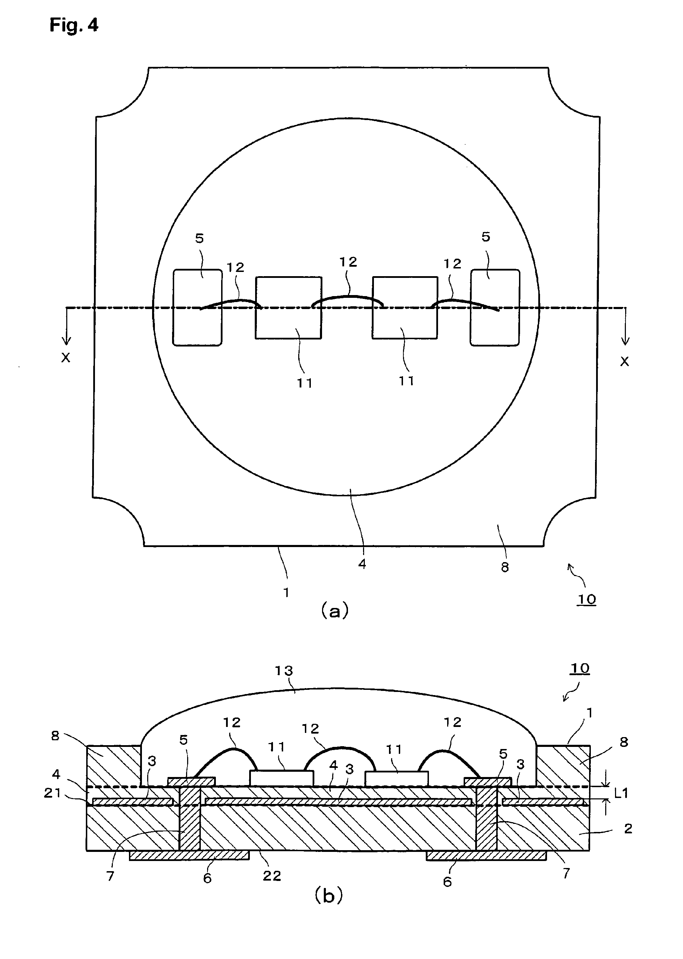

Fig. 4 is a plan view (a) illustrating an example of the substrate 1 for light-emitting element according to the second embodiment of the present invention and the light-emitting device 10 employing it, and a cross-sectional view (b) along its X-X line.

The substrate 1 for light-emitting element of the present invention is one wherein, for example, as shown in Fig. 4, two light-emitting elements 11 are to be mounted so that they are electrically connected in series. This substrate 1 for light-emitting element is used as a light-emitting device 10 wherein light-emitting elements 11 are electrically connected in series by bonding wires 12, and a sealing layer 13 is provided to cover such light-emitting elements 11 and bonding wires 12. That is, in the light-emitting device 10 shown in Fig. 4, the portion excluding the light-emitting elements 11, the bonding wires 12 and the sealing layer 13 is the substrate 1 for light-emitting element of the present invention.

Here, the second embodiment of the present invention will be described with reference to a light-emitting device and a substrate for the light-emitting device wherein two light-emitting elements 11 are mounted so that they are electrically connected in series. However, the number of light-emitting elements to be mounted, the electrical connection method such as in series or in parallel in the case of mounting a plurality of light-emitting elements, etc. are not particularly limited. The constructions of individual components which will be described hereinafter, may suitably be adjusted depending upon the design of the light-emitting device to be used within the range of the present invention.

The substrate 1 for light-emitting element has a substantially flat plate-form substrate main body 2 which mainly constitutes the substrate. This substrate main body 2 is made of a sintered product of a first glass ceramics composition comprising a glass powder and a ceramics filler. The substrate main body 2 has, as its main surface 21, a surface on the side where a light-emitting element is to be mounted when used as a substrate for light-emitting element, and in this embodiment, a surface on the opposite side is regarded as a rear surface 22.

The shape, thickness, size, etc. of the substrate main body 2 are not particularly limited and may be the same as those which are commonly used as a substrate for light-emitting element. Further, with respect to the sintered product of the first glass ceramics composition comprising a glass powder and a ceramics filler to constitute the substrate main body 2, it is possible to use the same one as the sintered product of the first glass ceramics composition according to the above first embodiment.

On the rear surface 22 of the substrate main body 2, a pair of external connection terminals 6 are provided which are electrically connected to an exterior circuit, and inside of the substrate main body 2, a pair of via conductors 7 are provided which electrically connect the after-mentioned element connection terminals 5 and the above-mentioned external connection terminals 6. The via conductors 7 are provided to further pass through the insulating protective layer 4 formed on the main surface of the substrate main body 2 as described hereinafter.

On the main surface 21 of the substrate main body 2, a heat dissipation layer 3 having a flat surface, having a thickness of from 8 to 50 µm and composed of a metal material containing silver, is formed in such a shape to exclude the periphery of the main surface 21 of the substrate main body, and the portions where the above pair of via conductors 7 are provided and the vicinity around them. On the main surface 21 of the substrate main body, an insulating protective layer 4 made of a sintered product of a second glass ceramics composition comprising a glass powder and a ceramics filler and having a flat surface, is formed to cover the entirety of the above heat dissipation layer 3 including its edge.

Here, the via conductors 7 formed in the substrate main body 2 are provided in such a shape as to further pass through the inside of the insulating protective layer 4 from the surface (hereinafter referred to as a "lamination surface") of the insulating protective layer 4 on the side of the main surface 21 of the substrate main body to the surface on its opposite side. The insulating protective layer 4 is formed to cover the above heat dissipation layer 3 over the entire surface on the main surface 21 of the substrate main body excluding the portions where such via conductors 7 are provided, and light-emitting elements will be mounted on a surface (hereinafter referred to as a "mounting surface") on the side opposite to the above lamination surface.

The constituting material, thickness, surface properties, etc. of the heat dissipation layer 3 may be the same as of the heat dissipation layer 3 in the above first embodiment.

When a heat dissipation property is taken into consideration, the heat dissipation layer 3 is preferably formed to have an area as large as possible on the main surface 21 of the substrate main body 2. However, the insulating protective layer 4 to cover the heat dissipation layer 3 is bonded to the main surface 21 of the substrate main body in a region where the heat dissipation layer 3 is not formed on the main surface 21 of the substrate main body, and accordingly, the area for providing the heat dissipation layer 3 is adjusted to secure the bonding area within a range where the adhesion of the two can be maintained. Further, the distance between the heat dissipation layer 3 and the via conductors 7 may be a distance where electrical insulation can be secured, but in consideration of e.g. a possible trouble from the viewpoint of the production, the distance is preferably at least 100 µm, more preferably at least 150 µm.

Further, in the substrate 1 for light-emitting element of the present invention, a metal having a thermal conductivity and not containing silver, such as a metal layer made of copper, may be provided between the heat dissipation layer 3 and the substrate main body 2, for the purpose of e.g. further increasing the heat dissipation property, as the case requires, within a range not to impair the surface planarity of the heat dissipation layer 3.

In the second embodiment of the present invention, the insulating protective layer 4 is made of a sintered product of the second glass ceramics composition comprising a glass powder and a ceramics filler. The thickness of the insulating protective layer 4 is preferably from 5 to 150 µm, more preferably from 75 to 125 µm, in consideration of e.g. the economical efficiency, a deformation due to the difference in thermal expansion from the substrate main body, etc., while securing an adequate function for protection of insulation, although it may depend also on the design of the light-emitting device. Here, the thickness of the insulating protective layer 4 is meant for the thickness of the insulating protective layer 4 to cover the above heat dissipation layer 3 and is the thickness shown by L1 in Fig. 4(b).

The insulating protective layer 4 has a flat surface, and as such surface planarity, specifically, the surface roughness Ra is preferably at least 0.03 µm, more preferably at most 0.01 µm, at least at a portion where the light-emitting element 11 is to be mounted, from the viewpoint of the production efficiency while securing an adequate heat dissipation property.

As the material to constitute the insulating protective layer 4, the sintered product of the second glass ceramics composition comprising a glass powder and a ceramics filler, may be used without any particular restriction, so long as it is one capable of securing the above surface roughness Ra. Specifically, in the above glass ceramics composition for the substrate main body, by taking the kneading time in the paste preparation step, the ceramics filler will be pulverized, and the surface roughness Ra can be made to be within the above range.

Further, the sintered product of the second glass ceramics composition to constitute the insulating protective layer 4 is preferably the same as the sintered product of the first glass ceramics composition as a constituting material of the substrate main body 2, when the adhesion with the above substrate main body 2 is taken into consideration. However, in consideration of the reflectivity to reflect light from light-emitting elements in a light extraction direction, it is also possible to employ a glass ceramics composition having a composition different from the first glass ceramics composition.

As a glass ceramics composition in order to increase the reflectivity, for example, in the above-mentioned glass ceramic composition for substrate main body, a glass ceramics composition is preferred wherein as the glass powder, the same one is used, and as the ceramics filler, a mixture of an alumina powder and a zirconia powder is used. The mixture of an alumina powder and a zirconia powder is preferably a mixture wherein the mixing ratio of the alumina powder: the zirconia powder is from 90:10 to 50:50 by mass ratio, and particularly preferred is a mixture of from 70:30 to 50:50. Further, the mixing ratio of the glass powder to such a ceramics filler is preferably from 30:70 to 50:50 by mass ratio.

Further, the sintered product of this glass ceramics composition may be used as the material to constitute the substrate main body 2.

Here, in a substrate for light-emitting element, it is common to provide a thermal via immediately under the mounting portion for a light-emitting element in order to obtain a sufficient heat dissipation property. In such a case, a special method is employed in order to suppress surface irregularities at the mounting portion which are likely to result by forming the thermal via, but even by using such a method, the difference in height between the highest portion and the lowest portion of the surface irregularities can be suppressed merely at a level of at most 1 µm.

In the present invention, by the above construction, a sufficient heat dissipation property can be secured without providing a thermal via which is likely to cause the surface roughness at the light-emitting element-mounting portion, and therefore, the difference in height between the highest portion and the lowest portion of the surface irregularities at the light-emitting element-mounting portion is equal to the surface other than the mounting portion i.e. the surface of the insulating protective layer in the present invention and is usually at most 0.5 µm. That is, as compared with a case where the above thermal via is provided, by the construction of the present invention, while the heat dissipation property is equal, with respect to the planarity of the mounting portion, a high planarity can be obtained more easily than providing a thermal via.

The substrate 1 for light-emitting element has a frame member 8 along the periphery of the mounting surface of the insulating protective layer 4 to form a cavity having a bottom surface (hereinafter referred to as "cavity bottom surface") constituted by a circular portion at the center of the mounting surface of the insulating protective layer 4. The material to constitute the frame member 8 is not particularly limited, but it is preferred to use the same one as the material to constitute the substrate main body 2 or the insulating protective layer 4. When the adhesion is taken into consideration, it is particularly preferred to use the same one as the material to constitute the insulating protective layer 4.

At the time of preparing a light-emitting device 10 by using the substrate 1 for light-emitting element, as shown in Fig. 4, on the mounting surface of the insulating protective layer 4, the above two light-emitting elements 11 are mounted substantially at the center portion of the cavity bottom surface so that the centers of such two light-emitting elements 11 are disposed on a straight line passing through the center of the cavity bottom surface.

In the substrate 1 for light-emitting element, on the mounting surface of the insulating protective layer 4, a pair of element connection terminals 5 are provided substantially in a rectangular shape each electrically connected to one of the pair of electrodes of the above-mentioned two light-emitting elements 11, so that they are electrically connected to the above via conductors 7, at the periphery outside the above two light-emitting elements 11, specifically, as opposed to both sides.

Here, with respect the element connection terminals 5, the external connection terminals 6 and the via conductors 7, so long as they are electrically connected in the order of the light-emitting elements, the element connection terminals 5, the via conductors 7, the external connection terminals 6 and the external circuit, their positions or shapes are not limited to those shown in Fig. 4 and may be optionally adjusted.

The material to constitute such element connection terminals 5, external connection terminals 6 and via conductors 7, i.e. wiring conductors, is not particularly limited so long as it is the same constituting material as wiring conductors to be commonly used for a substrate for light-emitting element, and the same material as described as a constituting material to be used for wring conductors in the above first embodiment may be used. Further, the element connection terminals 5 and the external connection terminals 6 may be constructed to have an electroconductive protective layer formed to cover their entirety, as the case requires, in the same manner as in the above first embodiment. Here, as such an electroconductive protective layer, it is possible to use the same one as described as the electroconductive protective layer in the above first embodiment, and the same applies to its preferred embodiment, specifically to the electroconductive protective layer having a gold-plated layer as the outermost layer, such as a gold plating or nickel/gold plating.

In the foregoing, the substrate 1 for light-emitting element according to the second embodiment of the present invention has been described. A light-emitting device 10 according to the second embodiment of the present invention is one wherein two light-emitting elements 11 such as light-emitting diode elements are mounted on the above prescribed mounting portions of such a substrate 1 for light-emitting element by a die bond agent such as a silicone die bond agent, so that they are electrically connected in series.

Specifically, one of the pair of electrodes of each of the two light-emitting elements 11 located outside is electrically connected to an element connection terminal 5 located outside of each light-emitting element 11 via a bonding wire 12. Further, one of the pair of electrodes of each of the two light-emitting elements 11 located inside is electrically connected to each other via a bonding wire 12. Further, the light-emitting device 10 is constituted by providing a sealing layer 13 to cover the light-emitting elements 11 and the bonding wires 12 and to fill the cavity.

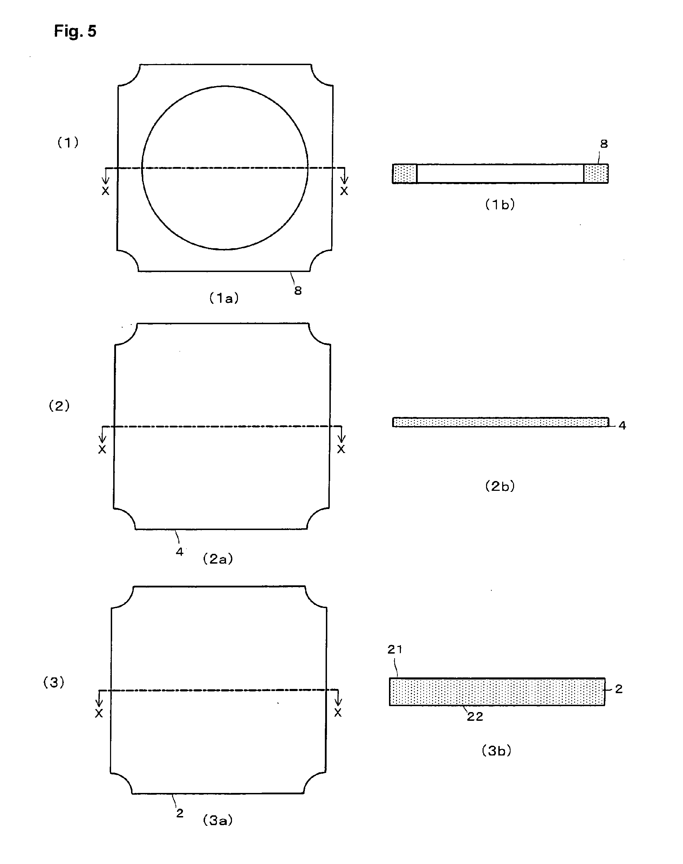

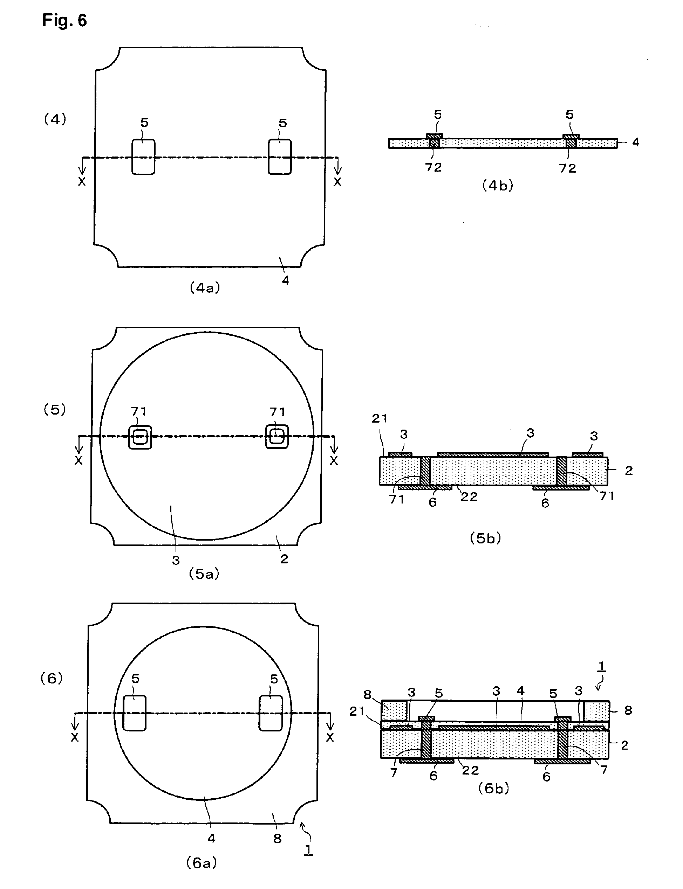

The substrate for light-emitting element according to the second embodiment of the present invention may, for example, be produced by a process comprising the following steps (A)' to (D)'. Now, the process will be described with reference to Figs. 5 and 6 by taking, as an example, the substrate 1 for light-emitting element of the light-emitting device 10 shown in Fig. 4, and components to be used for the production will be described by attaching the same symbols for the components in the completed product.

### (A)' GREEN SHEET-PREPARATION STEP

Firstly, by using a first glass ceramics composition comprising a glass powder and a ceramics filler, a substantially flat plate-form green sheet 2 for main body (Fig. 5(3) shows a plan view (3a) and a cross-sectional view (3b) along its X-X line) to constitute the substrate main body 2 of the substrate for light-emitting element, having, as the main surface 21, a surface on the side where light-emitting elements are to be mounted, by using a second glass ceramics composition comprising a glass powder and a ceramics filler, a green sheet 4 for insulating protective layer (Fig. 5(2) shows a plan view (2a) and a cross-sectional view (2b) along its X-X line) to constitute the insulating protective layer 4 of the substrate for light-emitting element, and a green sheet 8 for frame member (Fig. 5(1) shows a plan view (1a) and a cross-sectional view (1b) along its X-X line) to constitute the frame member 8, are prepared.

The green sheet 8 for frame member may be made of the above glass ceramics composition or may be made of the second glass ceramics composition. However, when the adhesion is taken into consideration, it is preferred to use the same second glass ceramics composition as the material to constitute the insulating protective layer 4. Further, the above first glass ceramics composition and the second glass ceramics composition may have different compositions or may have the same composition. The details of the glass ceramics compositions are as described above.

Each of such green sheets can be produced by adding a binder and, as the case requires, a plasticizer, a dispersing agent, a solvent, etc. to a glass ceramics composition comprising a glass powder and a ceramics filler to prepare a slurry, and forming the slurry into a sheet having a prescribed shape and thickness by e.g. a doctor blade method, followed by drying.

### (B)' CONDUCTOR PASTE LAYER-FORMING STEP

Prescribed conductor paste layers are formed at prescribed positions in the green sheet 2 for main body and the green sheet 4 for insulating protective layer obtained in the above step (A)'.

Fig. 6(4) shows views illustrating the green sheet 4 for insulating protective layer after formation of the conductor paste layers ((4a) is a plan view, and (4b) is a cross-sectional view along its X-X line). In the green sheet 4 for insulating protective layer, paste layers 72 for via conductors are formed to constitute parts of via conductors 7 at prescribed two locations, and substantially rectangular paste layers 5 for element connection terminals are formed on the surface on which the light-emitting elements are to be mounted, to cover the paste layers 72 for via conductors.

Fig. 6(5) is views illustrating the green sheet 2 for main body after forming the conductor paste layers ((5a) is a plan view, and (5b) is a cross-sectional view along its X-X line).

In the conductor paste layer-forming step, at prescribed two locations in the green sheet 2 for main body, paste layers 71 for via conductors to constitute parts of via conductors 7 passing-through from the main surface 21 to the rear surface 22 and paste layers 6 for external connection terminals on the rear surface 22 to be electrically connected with the paste layers 71 for via conductors, are formed. Further, on the main surface 21 of the green sheet 2 for main body, a metal paste layer 3 for heat dissipation layer containing a metal material containing silver is formed by screen printing in a region to exclude the periphery of the main surface 21 of the green sheet 2 for main body, and the portions where the above pair of via conductors 71 are formed and the vicinity around them.

With respect to the wiring conductor pastes such as the element connection terminal paste, the via conductor paste and the external connection terminal paste, to be used for forming such conductor paste layers, and the metal paste for dissipation layer, the same ones as described for the above first embodiment may be used, and the forming method may be the same.

### (C)' LAMINATION STEP

On the main surface 21 of the green sheet 2 for main body provided with the conductor paste layers, obtained in the above step (B)', the green sheet 4 for insulating protective layer provided with the conductive paste layers is laminated so that the surface (light-emitting element-mounting surface) on which the element connection terminal paste layers 5 are formed faces upward. Further, the green sheet 8 for frame member obtained in the above step (A)' is laminated thereon to obtain a non-sintered substrate 1 for light-emitting element.

### (D)' FIRING STEP

After the above step (C)', the obtained non-sintered substrate 1 for light-emitting element was subjected to binder burn out to remove the binder, etc., as the case requires, and then firing (firing temperature: 800 to 880°C) is carried out to sinter the glass ceramics composition, etc. This firing step can be carried out in the same manner as (E) firing step in the process for producing the substrate for light-emitting element of the above-described first embodiment.

Thus, the non-sintered substrate 1 for light-emitting element is fired to obtain a substrate 1 for light-emitting element. After the firing, as the case requires, an electroconductive protective layer which is commonly used for protection of conductors in a substrate for light-emitting element and which is formed by e.g. nickel plating, chromium plating, silver plating, silver/nickel plating, gold plating or nickel/gold plating as described above, may be provided to cover the entirety of the element connection terminals 5 and external connection terminals 6. The metal-plated layer to constitute the above electroconductive protective layer is preferably a nickel/gold-plated layer and may be formed in the same manner as described for the above first embodiment.

In the foregoing, the process for producing the substrate for light-emitting element according to the second embodiment of the present invention has been described, but the green sheet 2 for main body, the green sheet 4 for insulating protective layer and the green sheet 8 for frame member may not necessarily composed of a single green sheet and may be one wherein a plurality of green sheets are laminated. Further, the order to form the respective components, etc. may also be suitably changed within a range where the production of the substrate for light-emitting element is possible.

In the foregoing, the first embodiment of the present invention wherein a glass layer is used as the insulating protective layer and the second embodiment of the present invention wherein a sintered product layer of a second glass ceramics composition comprising a glass powder and a ceramics filler is used as the insulating protective layer, have been described with reference to the respective examples of the substrates for light-emitting elements and light-emitting devices employing them. However, the substrate for light-emitting element and the light-emitting device of the present invention are not limited thereto. Within the range of the concept of the present invention and as the case requires, their constructions may suitably be changed.

By the substrate for light-emitting element of the present invention, it is possible to sufficiently dissipate heat generated from light-emitting elements without requiring an increase of the production step such as thermal vias or heat dissipation component which requires a large amount of silver or the like to be filled therein. Further, according to the light-emitting device of the present invention, the substrate for light-emitting element of the present invention with a good heat dissipation property is used, whereby it is possible to suppress an excessive temperature rise of light-emitting elements to obtain an emission with high brightness. Such a light-emitting device of the present invention is useful as a backlight for e.g. mobile phones, liquid crystal displays, etc., as illumination for automobiles or decorations, or as other light sources.

### EXAMPLES

Now, the present invention will be described in detail with reference to Examples. However, it should be understood that the present invention is by no means restricted to such Examples.

### EXAMPLE 1

By the following process, a light-emitting device for test having the same construction as shown in Fig. 4 was prepared. Here, in the same manner as above, the same symbols are used for the components before and after the firing.

Firstly, a green sheet 2 for main body to prepare the substrate main body 2 of the substrate 1 for light-emitting element, a green sheet 4 for insulating protective layer and a green sheet 8 for frame member were prepared. For each green sheet, raw materials were blended and mixed so that SiO₂ became 60.4 mol%, B₂O₃ 15.6 mol%, Al₂O₃ 6 mol%, CaO 15 mol%, K₂O 1 mol% and Na₂O 2 mol%, and this raw material mixture was put into a platinum crucible and melted at 1,600°C for 60 minutes. Then, this molten state glass was cast and cooled. This glass was ground by a ball mill made of alumina for 40 hours to obtain a glass powder for the substrate main body. Here, ethyl alcohol was used as the solvent at the time of grinding.

40mass% of this glass powder for substrate main body, 51 mass% of an alumina filler (tradename: AL-45H manufactured by Showa Denko K.K.) and 9 mass% of zirconia filler (tradename: HSY-3F-J manufactured by Daiichi Kigenso Kagaku Kogyo Co., Ltd.) were blended and mixed to prepare a glass ceramics composition. To 50 g of this glass ceramics composition, 15 g of an organic solvent (a mixture of toluene, xylene, 2-propanol and 2-butanol in a mass ratio of 4:2:2:1), 2.5 g of a plasticizer (di-2-ethylhexyl phthalate), 5 g of polyvinyl butyral (tradename: PVK #3000K manufactured by DENKI KAGAKU KOGYO KABUSHIKI KAISHA) as a binder and a dispersing agent (tradename: BYK180 manufactured by BYK Japan KK) were blended and mixed to prepare a slurry.

This slurry was applied on a PET film by a doctor blade method, and dried to obtain a green sheet, and such green sheets were laminated to prepare a substantially flat plate-form green sheet 2 for main body which would have a thickness of 0.2 mm after firing, and a substantially flat plate-form green sheet 4 for insulating protective layer which would have a thickness of 0.1 mm after firing (thickness of the covered portion of the heat dissipation layer: represented by L1 in Fig. 4(b)), a green sheet 8 for frame member wherein the outer shape of the frame was the same as the green sheet 2 for main body, the shape in the frame is circular with a diameter of 4.3 mm, and the frame height after firing would be 0.5 mm.

On the other hand, a conductive powder (tradename: S550 manufactured by Daiken Chemical Co., Ltd.) and ethyl cellulose as a vehicle were blended in a mass ratio of 85:15 and dispersed in α-terpineol as a solvent so that the solid content would be 85 mass%. Then, kneading was carried out in a porcelain mortar for 1 hour, and further, dispersion was carried out three times by a three roll mill to prepare a wiring conductor paste.

Further, a metal paste for a heat dissipation layer was produced by blending a silver powder (tradename: S400-2 manufactured Daiken Chemical Co., Ltd.) and ethyl cellulose as a vehicle in a mass ratio of 90:10 and dispersed in α-terpineol as a solvent so that the solid content would be 87 mass%, followed by kneading for 1 hour in a porcelain mortar and further by dispersion three times by a three roll mill.

Through-holes having a diameter of 0.3 mm were formed in the green sheet for main body at portions corresponding to via conductors 7 by means of a punching machine and filled with the wiring conductor paste by a screen printing method to form via conductor paste layers 71, and at the same time, on the rear surface 22, external connection terminal conductor paste layers 6 were formed. Further, on the main surface 21 of the green sheet 2 for main body, a metal paste layer 3 for heat dissipation layer was formed by screen printing in a region excluding the periphery of the green surface 21 of the green sheet 2 for main body, and the portions where the above pair of via conductors 7 were provided and the vicinity around them, so that the thickness after firing would be 15 µm, to obtain the green sheet 2 for main body provided with conductor paste layers. Further, the surface roughness Ra of the heat dissipation layer 3 after firing was confirmed to be 0.08 µm from the measurement by SURFCOM 1400D manufactured by Tokyo Seimitsu Co., Ltd.

Through-holes having a diameter of 0.3 mm were formed in the green sheet 4 for insulating protective layer at portions corresponding to the via conductors 7 by means of a punching machine and filled with a wiring conductor paste by a screen printing method to form via conductor paste layers 72, and at the same time, on the surface on which light-emitting elements were to be mounted, substantially rectangular element connection terminal paste layers 5 were formed by a screen printing method to cover the via conductor paste layers 72, to obtain a green sheet 4 for insulating protective layer provided with conductor paste layers.

On the main surface 21 of the green sheet 2 for main body provided with the conductor paste layers, obtained as described above, the green sheet 4 for insulating protective layer provided with the conductor paste layers was laminated so that the surface (light-emitting element-mounting surface) having element connection terminal paste layers 5 formed, faced upward. Further, the green sheet 8 for frame member obtained as described above was laminated thereon to obtain a non-sintered substrate 1 for light-emitting element.

The non-sintered substrate 1 for light-emitting element obtained as described above, was held at 550°C for 5 hours to carry out binder burn out and further held at 870°C for 30 minutes to carry out firing, to obtain a substrate 1 for light-emitting element for test. The surface roughness Ra of the surface of the insulating protective layer 4 in the obtained substrate 1 for light-emitting element was confirmed to be 0.01 µm from the measurement by 1400D manufactured by Tokyo Seimitsu Co., Ltd.

Two 2-wire type light-emitting diode elements were mounted on the substrate 1 for light-emitting element for test, prepared as described above, between the pair of element connection terminals 5 on the mounting surface of the insulating protective layer 4, to prepare a light-emitting device 10. Specifically, light-emitting diode elements 11 (tradename: GQ2CR460Z manufactured by Showa Denko K.K) were fixed at the above-mentioned positions by a die bond material (tradename: KER-3000-M2, manufactured by Shin-Etsu Chemical Co., Ltd.), and one of the pair of electrodes of each of the two light-emitting elements 11, located outside, and the element connection terminal 5 located outside each light-emitting element 11, were electrically connected via a bonding wire 12. Further, one of the pair of electrodes of each of the two light-emitting elements 11 located inside was electrically connected to each other via the bonding wire 12.

Further, using a sealing agent (tradename: SCR-1016A manufactured by Shin-Etsu Chemical Co., Ltd.), sealing was carried out to form the sealing layer 13 as shown in Fig. 4. As the sealing agent, one containing a phosphor (tradename: P46-Y3 manufactured by Mitsubishi Chemical Holdings Corporation) in an amount of 20 mass% to the sealing agent, was used.

### EXAMPLE 2

In Example 2, a light-emitting device for test having the same construction as shown in Fig. 4 was prepared in the same manner as in Example 1 except that the proportions of the components of the glass ceramics composition used for the preparation of each green sheet in the above Example 1 were changed so that the glass powder for substrate main body became 38 mass%, the alumina filler (tradename: AL-45H manufactured by Showa Denko K.K.) 38 mass% and zirconia filler (tradename: HSY-3F-J manufactured by Daiichi Kigenso Kagaku Kogyo Co., Ltd.) 24 mass%.

### COMPARATIVE EXAMPLE

A light-emitting device having a conventional construction was prepared as a Comparative Example in the same manner as in Example 1 except that in Example 1, immediately under light-emitting elements 11, one thermal via having a diameter of 0.2 mm was formed for each light-emitting element.

### <Evaluation>

With respect to the light-emitting devices obtained in the above Examples 1 and 2 and Comparative Example, the total luminous flux and the thermal resistance were measured by the following methods.

### [Total luminous flux]

The measurement of the total luminous flux of the light-emitting device was carried out by using a LED total luminous flux-measuring device (tradename: SOLIDLAMBDA·CCD·LED·MONITOR·PLUS manufactured by Spectra Co-op). The integrating sphere was 6 inches, and as a voltage/current generator, R6243 manufactured ADVANTEST Corporation was used. Further, the measurement was carried out by applying 35 mA to the light-emitting diode element.

### [Thermal resistance]

The thermal resistance of the substrate for light-emitting element in the light-emitting device was measured by using a thermal resistance-measuring device (tradename: TH-2167 manufactured by MINEKOONDENKI). Here, the applied electric current was 35 mA, and the current was applied until the voltage drop was saturated, whereupon the saturation temperature was calculated by the temperature coefficient led from the dropped voltage and the temperature-voltage drop properties of the light-emitting diode element, and the thermal resistance was obtained.

The results are shown in Table 1. Here, the results are shown by percentages when the total luminous flux and the thermal resistance in the conventional light-emitting device of Comparative Example were regarded as 100%.

**TABLE 1**

| | Total luminous flux (%) | Thermal resistance (%) |
|---|---|---|
| Comparative Example | 100 | 100 |
| Example 1 | 103 | 100 |
| Example 2 | 106 | 100 |

By the substrate for light-emitting element of the present invention, it is possible to sufficiently dissipate heat generated from light-emitting elements without requiring an increase of a production step such as a thermal via or without a heat dissipating component requiring a large amount of silver or the like to be filled therein, and when formed into a light-emitting device, it is possible to suppress an excessive temperature rise of light-emitting elements and to obtain an emission with high brightness. A light-emitting device of the present invention using such a substrate for light-emitting element, is useful as a backlight for e.g. mobile phones or liquid crystal displays, as illumination for automobiles or decorations, or as other light sources.

1: substrate for light-emitting element, 2: substrate main body, 3: heat dissipation layer, 4: insulating protective layer, 5: element connection terminal, 6: external connection terminal, 7: via conductor, 8: frame member, 10: light-emitting device, 11: light-emitting element, 12: bonding wire, 13: sealing layer, 21: main surface of substrate main body, 22: rear surface of substrate main body

The entire disclosures of Japanese Patent Application No. 2010-068812 filed on March 24, 2010 and Japanese Patent Application No. 2010-235799 filed on October 20, 2010 including specifications, claims, drawings and summaries are incorporated herein by reference in their entireties.

## Claims

1. A substrate for light-emitting element, which comprises:
a substrate main body made of a sintered product of a first glass ceramics composition comprising a glass powder and a ceramics filler, wherein a surface on the side where a light-emitting element is to be mounted, is regarded as its main surface, and parts of wiring conductors for electrically connecting electrodes of the light-emitting element and an external circuit, are provided on the main surface,
a heat dissipation layer formed on the substrate main body in such a shape to exclude said parts of wiring conductors and the vicinity around them and the periphery of the main surface, made of a metal material containing silver, having a thickness of from 8 to 50 µm and having a flat surface, and
an insulating protective layer formed to cover the entirety of the heat dissipation layer including its edge and having a flat surface.

2. The substrate for light-emitting element according to Claim 1, wherein the substrate main body has no thermal via.

3. The substrate for light-emitting element according to Claim 1 or 2, wherein the heat dissipation layer has a surface roughness Ra of at most 0.15 µm at least at a portion where the light-emitting element is to be mounted.

4. The substrate for light-emitting element according to any one of Claims 1 to 3, wherein the insulating protective layer has a surface roughness Ra of at most 0.03 µm at least at a portion where the light-emitting element is to be mounted.

5. The substrate for light-emitting element according to any one of Claims 1 to 4, wherein the insulating protective layer has a thickness of from 5 to 150 µm.

6. The substrate for light-emitting element according to any one of Claims 1 to 5, wherein the insulating protective layer is made of a sintered product of a second glass ceramics composition comprising glass or a glass powder and a ceramics filler.

7. The substrate for light-emitting element according to Claim 6, wherein the ceramics filler contained in the second glass ceramics composition is a mixture of an alumina powder and a zirconia powder.

8. The substrate for light-emitting element according to any one of Claims 1 to 7, wherein the wiring conductors have, as parts thereof, element connection terminals to be connected to the electrodes of the light-emitting element and external connection terminals to be connected to an external circuit, and an electroconductive protective layer is formed on both terminals to cover their entirety including their edges.

9. The substrate for light-emitting element according to Claim 8, wherein the electroconductive protective layer is a metal-plated layer having a gold-plated layer at least as the outermost layer.

10. A light-emitting device comprising the substrate for light-emitting element as defined in any one of Claims 1 to 9, and a light-emitting element mounted thereon.
